# EUROPEAN PATENT APPLICATION

(11) **EP 4 518 627 A2**
(43) Date of publication of application: **05.03.2025**
(21) Application number: 24197455.9
(22) Date of filing: 30.08.2024
(51) Int. Cl.: H10K 59/124, H10K 59/131, H10K 59/80, G03G 15/04

(54) **LIGHT EMITTING DEVICE**

(30) Priority: 31.08.2023 JP 2023141383; 10.06.2024 JP 2024093445
(71) Applicant: CANON KABUSHIKI KAISHA, Tokyo 146-8501 (JP)
(72) Inventor: NAGASAKI, Mizuki, Tokyo (JP); RYOKI, Tatsuya, Tokyo (JP)
(74) Representative: WESER & Kollegen Patentanwälte PartmbB

(57) **Abstract**

A light emitting device includes a substrate (101) having a polygonal shape, a light emitting region (102) including a plurality of light emitting elements and each light emitting element having a first electrode and a second electrode, a first contact region (103_1) disposed in a peripheral region of the light emitting region, and a moisture-resistant ring (100). The first electrode is provided on each of the light emitting elements, and the second electrode is a common electrode shared by the light emitting elements, the moisture-resistant ring (100) has a first part disposed at a position at a first distance from the long side, and a second part disposed at a position at a second distance from the long side, and the first contact region (103_1) is disposed between the second part of the moisture-resistant ring and the light emitting region (102) in the second direction.

## Description

### BACKGROUND OF THE INVENTION

### Field of the Invention

The present disclosure relates to a light emitting device, for example, a light emitting device having a light emitting element.

### Description of the Related Art

An optical writing device (OLED-PH: OLED Print Head) for use in an image forming apparatus, which uses an organic light emitting diode (OLED) as a light emitting source, has been proposed. The OLED-PH is advantageous for reduction in size and costs since the OLED and transistors for driving the OLED can be formed on the same substrate. In particular, in a case where a silicon wafer is used as the substrate, it is possible to form a driving circuit finely. As a result, it is possible to increase the density of the OLED, which serves as the light emitting source. Accordingly, it is possible to form higher-definition images.

Japanese Patent Application Publication No. 2021-30565 discloses an OLED-PH in which a plurality of rectangular light emitting devices each having a plurality of OLEDs are arranged in a line. In the OLED-PH, each light emitting device has a plurality of OLEDs that are supplied with current through a common power source wiring. Accordingly, reduction in costs of the OLED-PH can be further achieved by reducing the costs of the light emitting device.

Here, the light emitting device can be obtained by forming the plurality of light emitting devices on the substrate and then cutting the substrate out to obtain individual light emitting devices. Accordingly, reduction in costs can be achieved by increasing a yield of the light emitting devices on one substrate.

Further, in each OLED in Japanese Patent Application Publication No. 2021-30565, a lower electrode is an independent electrode, and an upper electrode is a common electrode. Since the upper electrode is made of a material that is transparent to the emission wavelength of the light emitting layer, a resistance thereof is generally high. Furthermore, since the upper electrode is a common electrode, the driving current of the plurality of OLEDs flows into the upper electrode, and voltage drop is large. As a result, unevenness in light emission brightness may occur. In order to suppress the voltage drop of the upper electrode, it is desirable to have a plurality of contact regions between the upper electrode and a low resistance wiring for supplying a potential to the upper electrode.

In the manufacturing process of OLEDs, the electrodes and organic layers are deposited on the substrate through vacuum deposition, which uses a deposition mask, to form an OLED. The deposition mask tends to be bent since an opening area thereof is large. The bending of the deposition mask is suppressed by bringing a part of the deposition mask into direct contact with the substrate. For this reason, columnar structures for direct contact, called ribs, are formed on the deposition mask. In a case of the rectangular light emitting device, an opening aspect ratio of the deposition mask becomes large, and the mask tends to be bent in the long side direction of the opening. For this reason, it is necessary for rib direct-contact regions to be disposed along the long side between adjacent light emitting devices in the short side direction.

As described above, in order to suppress the voltage drop of the upper electrode (common electrode), it is effective for the contact regions to be disposed between the upper electrode and the low resistance wiring for supplying a potential to the upper electrode along the long side direction. On the other hand, it is necessary for the rib direct-contact regions to be disposed in the long side direction. Therefore, it is necessary for the contact regions be disposed to avoid interference with terminal pad portions and the rib direct-contact regions for electrical connection to the outside.

For example, the contact regions, the terminal pad portions, and the rib direct-contact regions can be disposed in this order from the OLED disposition region in the short side direction. However, such a disposition increases the chip size, thereby reducing the yield of light emitting devices per substrate and hindering reduction in costs.

### SUMMARY OF THE INVENTION

The present disclosure provides a light emitting device capable of improving the yield and achieving reduction in costs.

According to some embodiments, it is provided a light emitting device as specified in claims 1 to 18. In addition, it is provided an image forming apparatus as specified in claims 19 and 20.

Further features of the present invention will become apparent from the following description of exemplary embodiments with reference to the attached drawings.

### BRIEF DESCRIPTION OF THE DRAWINGS

FIGS. 1A to 1C show substrate disposition and disposition of a deposition mask of light emitting devices according to Example 1;
FIG. 2 is a cross-sectional view of an example of the light emitting device according to Example 1;
FIG. 3 is a plan view of an example of the light emitting device according to Example 1;
FIG. 4A is a cross-sectional view of an example of the light emitting device in FIG. 3 taken along the A-A' plane;
FIG. 4B is a cross-sectional view of an example of the light emitting device in FIG. 3 taken along the B-B' plane;
FIG. 5 is a plan view of an example of a light emitting device according to Example 2;
FIG. 6 is a plan view of an example of the light emitting device according to Example 2;
FIG. 7 is a cross-sectional view of an example of the light emitting device in FIG. 6 taken along the C-C' plane; and
FIGS. 8A to 8C are diagrams showing a configuration of an image forming apparatus according to Example 3.

### DESCRIPTION OF THE EMBODIMENTS

### Example 1

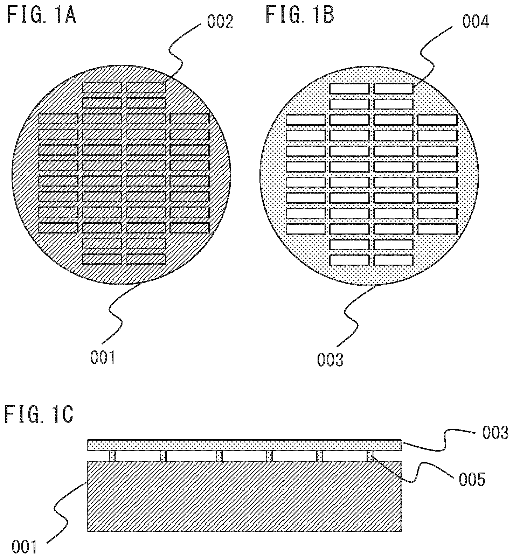

An example of a light emitting device according to the present disclosure will be described with reference to FIGS. 1A-1C, 2, 3, 4A, and 4B. It should be noted that the following embodiments are merely examples of the present invention, and the values, shapes, materials, components, dispositions of the components, and connection forms do not limit the present invention.

In the following description, an OLED will be used as an example of a light emitting element. It should be noted that the present disclosure is not limited to the OLED, and can be applied to current-driven light emitting devices in general.

FIG. 1A shows an example of light emitting devices 002 according to the present example that is formed on a silicon wafer 001. The light emitting devices 002 are formed in a shape of rows and columns on the silicon wafer 001. In the case of a polygonal (for example, rectangular) light emitting device having long and short sides, the yield from one silicon wafer varies greatly depending on the size of the short side. Therefore, making the short side as short as possible is effective in achieving reduction in costs. Further, in a case where a silicon wafer is used as the substrate, it becomes possible to finely form a driving circuit. As a result, it is possible to increase a density of OLEDs. By increasing the density, it is possible to form higher-definition images.

FIG. 1B shows an example of a deposition mask 003 for forming the OLEDs on the light emitting devices 002. The deposition mask 003 has a plurality of openings 004 disposed therein, and the openings 004 and the light emitting devices 002 are disposed at equal intervals. After the light emitting devices 002 on the silicon wafer 001 and the openings 004 of the deposition mask 003 are overlapped in a plan view, the silicon wafer 001 and the deposition mask 003 are brought into close contact with each other, and the electrodes and organic layers are deposited on the light emitting devices through vacuum deposition, thereby forming the OLEDs.

FIG. 1C shows an example of the cross-sectional structure of the silicon wafer 001 and the deposition mask 003 which are in close contact with each other. Ribs 005 are disposed on the deposition mask 003. The ribs 005 allow the silicon wafer 001 and the deposition mask 003 to maintain a constant distance apart in a case where the silicon wafer 001 and the deposition mask 003 are in close contact with each other. Further, the ribs 005 minimize an area in which the deposition mask 003 is in contact with the light emitting devices 002, and suppress or prevent the transfer of foreign matter and scratches to the light emitting devices 002, thereby suppressing or preventing occurrence of sealing defects.

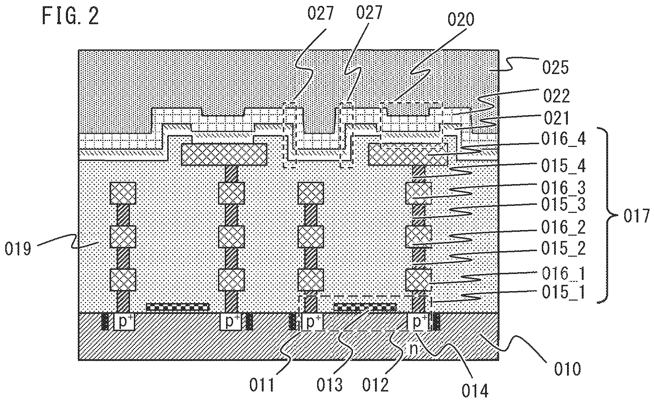

FIG. 2 is a schematic cross-sectional view showing an example of an OLED and a transistor connected to the OLED.

The transistor is an example of an active element. The transistor may be a thin film transistor (TFT). FIG. 2 shows an OLED 020 and a transistor 014.

The transistor 014 is disposed on a silicon substrate 010, and is configured to include a transistor gate 013, a transistor drain 012, and a transistor source 011.

There is a wiring 017 formed of a number of contact plugs 015_1 to 015_4 that electrically connect the transistor drain 012 and the OLED 020, and a number of metal wirings 016_1 to 016_4. An insulating layer 019 is provided between the wirings. In FIG. 2, the insulating layer 019 is shown as a single layer, but may have a laminated structure of a plurality of layers.

The OLED 020 is configured to include a first electrode 016-4, an organic compound layer 021 having a light emitting layer, and a second electrode 022.

In FIG. 2, the organic compound layer is shown as a single layer, but the organic compound layer 021 may be a plurality of layers. In the OLED 020, the second electrode 022 is a transparent electrode, and is able to extract light from the organic compound layer 021 to the outside. A protective layer 025 for reducing deterioration of the OLED is provided on the second electrode 022. The second electrode 022 of the OLED 020 is shared by the plurality of OLEDs 020 and serves as a common electrode.

In the light emitting device 002, the combination of the OLED 020 and the transistor 014 is repeatedly disposed in the row and column directions.

A structure 027, which has a large step in a layer immediately below the organic compound layer 021, is formed between the OLEDs 020. The structure 027 electrically isolates the organic compound layer 021 while forming electrical connection with the second electrode 022.

A method of electrical connection with the electrodes (source electrode, drain electrode) included in the transistor is not limited to an aspect shown in FIG. 2. Either the source electrode or the drain electrode of the transistor may be electrically connected in accordance with a polarity of the first electrode 016_4 and a polarity of the transistor.

In FIG. 2, the transistor is used as a switching element, but other switching elements may be used instead.

The transistor is not limited to a transistor using a monocrystalline silicon wafer, but may be a thin film transistor having an active layer on the insulating surface of the substrate. Examples of the active layer include monocrystalline silicon, amorphous silicon, and non-monocrystalline silicon such as microcrystalline silicon, and non-monocrystalline oxide semiconductors such as indium zinc oxide and indium gallium zinc oxide.

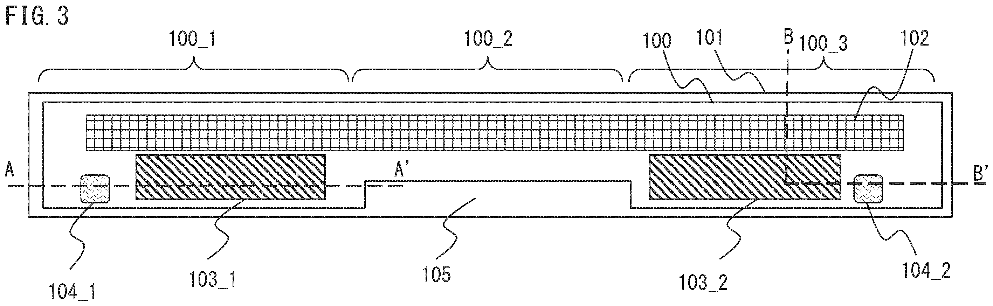

FIG. 3 is a schematic diagram showing one form of the light emitting device according to the present example. The light emitting device according to the present example has a rectangular shape with long sides parallel to a first direction and short sides parallel to a direction intersecting with the first direction.

In the light emitting device, in a case where a light emitting region is formed along a long side direction, members other than the light emitting region, such as the contact region, can be disposed to be adjacent to the light emitting region in a short side direction, in a peripheral region of the light emitting region.

A substrate 101 has a polygonal shape, and an example of a substrate 101 with a rectangular shape as an example of the polygonal shape will be described here. In the present specification, the long side direction of the rectangular substrate 101 is referred to as the first direction, and the short side direction perpendicular to the long side direction is referred to as a second direction. Further, the polygonal shape in the present specification also includes a shape with rounded corners. A moisture-resistant ring 100, which has a function of suppressing and preventing moisture from penetrating into the light emitting device, is disposed on the rectangular substrate 101. Furthermore, the light emitting region 102, the first contact region 103_1 and the second contact region 103_2, and the pads 104_1 and 104_2 are disposed inside the moisture-resistant ring 100. In the light emitting region 102, the light emitting elements are arranged in row and column directions. The first contact region 103_1 and the second contact region 103_2 are regions in which wiring electrically connected to the common electrode of the OLED is disposed. The pads 104_1 and 104_2 are electrically connected to the contact regions.

In the light emitting region 102, the plurality of light emitting elements are arranged in a shape of rows and columns. As described above, each light emitting element is configured to include a light emitting layer and a first electrode and a second electrode with the light emitting layer interposed therebetween. The first electrode is an independent electrode provided for each light emitting element, and the second electrode is a common electrode provided in common to all the light emitting elements.

The first contact region 103_1 and the second contact region 103_2 are adjacent regions of the light emitting region 102 of the substrate 101, and are provided inside the moisture-resistant ring 100. Further, a depressed portion 105, the first contact region 103_1, the second contact region 103_2, and the pads 104_1 and 104_2 are disposed between the light emitting region 102 and one long side end portion of the substrate 101. In other words, the depressed portion 105, the first contact region 103_1, the second contact region 103_2, and the pads 104_1 and 104_2 are disposed on the same side in the short side direction relative to the light emitting region 102. Furthermore, the depressed portion 105 is disposed between the first contact region 103_1 and the second contact region 103_2. Moreover, the depressed portion 105, the first contact region 103_1, the second contact region 103_2, and the pads 104_1 and 104_2 are disposed in series in the long side direction. In the example of FIG. 3, the pad 104_1, the first contact region 103_1, the depressed portion 105, the second contact region 103_2, and the pad 104_2 are disposed in series in the long side direction in this order.

The moisture-resistant ring 100 is a guard ring made of a wiring layer, and is provided to surround the light emitting region 102, the first contact region 103_1, the second contact region 103_2, and the pads 104_1 and 104_2. The moisture-resistant ring 100 has one or more depressed portions 105 on a side of one of the long sides of the substrate. The moisture-resistant ring 100 has a narrow-width portion 100_2 and wide-width portions 100_1 and 100_3 which are respectively provided on both sides of the narrow-width portion 100_2 in the long side direction (first direction). The wide-width portion described herein refers to a part in which a width of a shape of a part enclosed by the moisture-resistant ring 100 is wider than the other part in the minor axis direction. Similarly, the narrow-width portion refers to a part in which a width of a shape of a part enclosed by the moisture-resistant ring 100 is narrower than the other part in the minor axis direction. Thus, the width of the narrow-width portion 100_2 in the short side direction (second direction) is shorter than the width of the wide-width portions 100_1 and 100_3 in the short side direction, and the width of the wide-width portions 100_1 and 100_3 in the short side direction is longer than the width of the narrow-width portion 100_2 in the short side direction.

In other words, the moisture-resistant ring 100 has a first part and a second part that extend along one side of the substrate 101 (for example, a side extending in the long side direction or the first direction). A distance (first distance) from the one side of the substrate 101 (the side which the first part and the second part face, the lower side in FIG. 3) to the first part is greater than a distance (second distance) from the one side of the substrate 101 to the second part. That is, the distance from the one side of the substrate 101 to the first part is greater than the distance from the one side of the substrate to the second part. Thus, for example, the narrow-width portion 100_2 may have the first part. Further, the wide-width portion 100_1 or 100_3 may have the second part.

The positions of the narrow-width portion 100_2 and the wide-width portions 100_1 and 100_3 on one long side thereof in the short side direction are the same, and the positions thereof on the other long side in the short side direction are different. Due to the presence of the narrow-width portion 100_2, an outer circumference of the moisture-resistant ring 100 has a part having a depressed shape. The part is referred to as the depressed portion 105 in the present example. The depressed portion 105 is a direct-contact region for coming into direct contact with the ribs as a part of a mask for deposition in a film formation process. A width of the narrow-width portion 100_2 in the short side direction is less than widths of the wide-width portions 100_1 and 100_3 in the short side direction by the width of the depressed portion 105 in the short side direction. The first contact region 103_1 and the second contact region 103_2 are disposed in the wide-width portions 100_1 and 100_3 of the moisture-resistant ring 100, respectively. In other words, the first contact region 103_1 and the second contact region 103_2 are disposed to be adjacent to the second part of the moisture-resistant ring 100, in a region on the light emitting region side of the moisture-resistant ring 100.

The driving circuit for the light emitting device is formed inside the moisture-resistant ring 100 (not shown in the drawing). In a case where the OLED is formed, the ribs 005 of the deposition mask 003 comes into direct contact with the depressed portion 105 of the moisture-resistant ring 100, in other words, the outside of the moisture-resistant ring 100 at the narrow-width portion 100_2, thereby maintaining a certain distance. The ribs 005 minimize an area in which the deposition mask is in contact with the light emitting device, and suppress or prevent the transfer of foreign matter and scratches to the light emitting devices, thereby suppressing or preventing occurrence of sealing defects. Further, in a case where the ribs 005 come into direct contact with the substrate, an insulating film on the substrate may be scratched. As a result, there is a concern about deterioration in sealing performance of the light emitting device. In the present example, since the depressed portion 105, which is the direct-contact region of the ribs 005, is disposed on the outside of the moisture-resistant ring, the sealing performance of the device is ensured.

The second electrode (upper electrode/common electrode) 022 of the OLED in the present example is made of a transparent electrode material. Thus, the wiring resistance is relatively high. Further, since the second electrode 022 is also a common electrode, current flows from the plurality of OLEDs, and the voltage drop at the second electrode 022 becomes large. Therefore, a difference occurs in the voltage applied to each OLED depending on the distance from the contact region to which the potential is supplied. Thereby, an actual light emission brightness differs between the OLEDs to which a voltage for emitting light with the same brightness is applied, and shading and the like may occur.

The light emitting device according to the present example has at least two contact regions (103_1, 103_2) between the second electrode (upper electrode / common electrode) 022 and the power source wiring along the long side end portion of the light emitting device. A resistance of the second electrode 022 can be reduced by bringing the second electrode 022 into contact with the power source wiring having a low resistance at a plurality of positions in the long side direction. Therefore, even in a case where the plurality of OLEDs have the common second electrode 022, the position-dependent voltage drop of the second electrode 022 can be suppressed, and shading of the light emission brightness can be suppressed.

The first contact region 103_1 or the second contact region 103_2 and the direct-contact region of the ribs 005 of the deposition mask 003 may be disposed in series in the short side direction of the chip. However, in such a case, a region exclusively for the rib is provided between the light emitting devices in the short side direction, and the chip size increases by an area of the region exclusively for the rib. In the light emitting device according to the present example, the depressed portion 105 of the moisture-resistant ring, which is the rib direct-contact region, is disposed between the first contact region 103_1 and the second contact region 103_2. Therefore, the distance between the light emitting devices in the short side direction can be reduced. Thus, the number of light emitting devices that can be disposed in the short side direction in one silicon wafer can be increased, and the yield thereof can be increased.

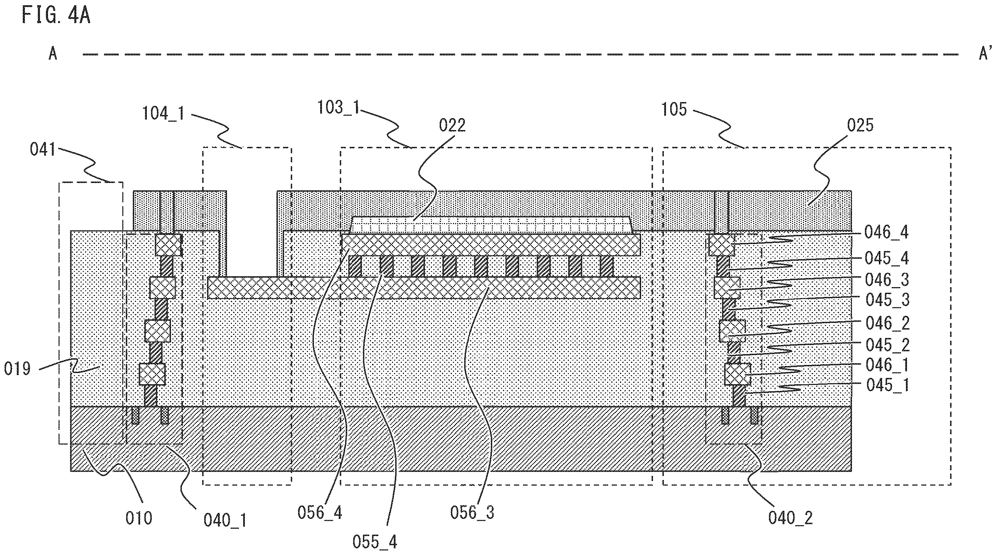

FIG. 4A is a cross-sectional view of the light emitting device of FIG. 3 taken along the line A-A'. The moisture-resistant ring 040_2 has a laminated structure in which contact plugs 045_1 to 045_4 and metal wirings 046_1 to 046_4 are laminated, and extends from the surface of the light emitting device to a depth that reaches the silicon substrate 010 on which the circuit elements are formed. The contact plugs 045_1 to 045_4 and the metal wirings 046_1 to 046_4 constituting the moisture-resistant ring 040_2 are formed in the same layer as the contact plugs 015_1 to 015_4 and metal wirings 016_1 to 016_4 constituting the wiring 017. In such a manner, the moisture-resistant ring 040 has the same layer structure as a multilayer wiring structure of an internal circuit, and can be formed simultaneously with the internal circuit through a common process.

A cross-sectional structure of the moisture-resistant ring 100 is the same as a structure of the moisture-resistant ring 040_2 at any location in the light emitting device. Therefore, the moisture-resistant ring 040_2 and the moisture-resistant ring 040_1 have the same cross-sectional structure.

The moisture-resistant rings 040_1 and 040_2 and the protective layer 025 of the OLED are in physical contact with each other, and have functions of reducing or preventing moisture penetration into the OLED.

In a scribe region 041, the protective layer 025 of the OLED is removed. Thereby, it is possible to reduce or prevent chipping of the protective layer 025 in a case of cutting the light emitting device from the silicon wafer.

In the contact region 103_1, the second electrode (common electrode) 022 of the OLED and the metal wiring 056-4 are in physical contact with each other. The pad 104_1 is configured to include the metal wiring 056_3 in the same layer as the metal wiring 046_3. A low-resistance power source wiring is laid from the pad 104_1 to immediately below the contact region 103_1, and the metal wiring 056_3 and the metal wiring 056_4 are electrically connected with low resistance through the contact plug 055-4. In the present example, the pad is in the same layer as the metal wiring 046_3, but the pad may be in the same layer as the metal wiring 046_4, and does not have to be limited to the pad in the cross-sectional structure of the present example.

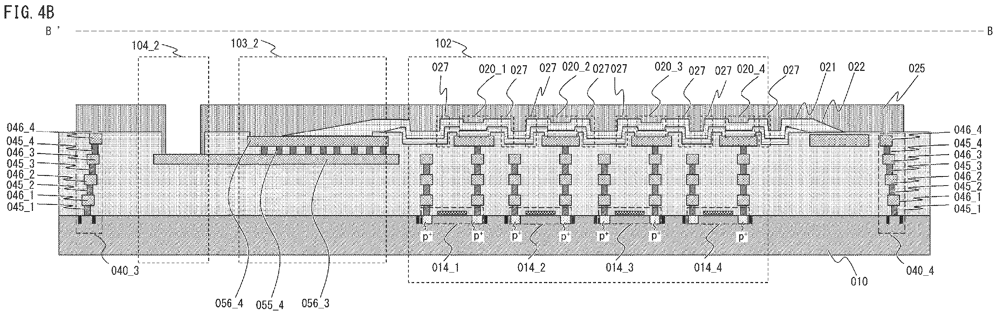

FIG. 4B is a cross-sectional view of the light emitting device of FIG. 3 taken along the line B-B'. The moisture-resistant ring 040_3 has a laminated structure in which the contact plugs 045_1 to 045_4 and the metal wirings 046_1 to 046_4 are laminated, and extends from the surface of the light emitting device to a depth that reaches the silicon substrate 010 on which the circuit elements are formed. The contact plugs 045_1 to 045_4 and metal wirings 046_1 to 046_4 constituting the moisture-resistant ring 040_3 can be formed in the same layer as the contact plugs 015_1 to 015_4 and metal wirings 016_1 to 016_4 constituting the wiring 017, for example. In such a manner, the moisture-resistant ring 040 has the same layer structure as a multilayer wiring structure of an internal circuit, and can be formed simultaneously with the internal circuit through a common process.

The cross-sectional structure of the moisture-resistant ring 100 may be the same as a structure of the moisture-resistant ring 040_1 at any location in the light emitting device. In such a case, the moisture-resistant rings 040_1, 040_3, and 040_4 have the same cross-sectional structure.

The moisture-resistant rings 040_1 to 040_4 and the protective layer 025 of the OLED are in physical contact with each other, and have functions of reducing or preventing moisture penetration into the OLED. Further, either one or a plurality of the contact plugs 045 and the metal wirings 046 of the moisture-resistant ring 040 may be partially replaced with a layer using the same material as the protective layer 025. Since the protective layer 025 is formed of a material capable of reducing moisture penetration, the moisture resistance of the moisture-resistant ring 040 can be maintained even in a case where such a replacement is performed.

In a scribe region 041, the protective layer 025 of the OLED is removed. Thereby, it is possible to reduce or prevent chipping of the protective layer 025 in a case of cutting the light emitting device from the silicon wafer.

Four light emitting elements 020_1 to 020_4 and four transistors 014_1 to 014_4 electrically connected to the light emitting elements are disposed in the light emitting region 102 along the B-B' cross section. In the contact region 103_2, the second electrode (common electrode) 022 of the OLED and the metal wiring 056-4 are in physical contact with each other. The pad 104_2 is configured to include the metal wiring 056_3 in the same layer as the metal wiring 046_3. A low resistance power source wiring 056_3 is drawn from the pad 104_2 to immediately below the contact region 103_2, and the metal wiring 056_3 and the metal wiring 056_4 are electrically connected with low resistance through the contact plug 055-4. In the present example, the pad is in the same layer as the metal wiring 046_3, but the pad may be in the same layer as the metal wiring 046_4, and is not limited to the pad in the cross-sectional structure of the present example.

By adopting the configuration described in the present example, it is possible to obtain effects of suppressing shading of the brightness of the light emitting device, improving the yield, and manufacturing at low cost.

### Example 2

A second example of the light emitting device according to the present disclosure will be specifically described. It should be noted that only parts different from the above-mentioned outline and the first example will be described, and the same or similar parts will be represented by the same reference numerals and will not be described.

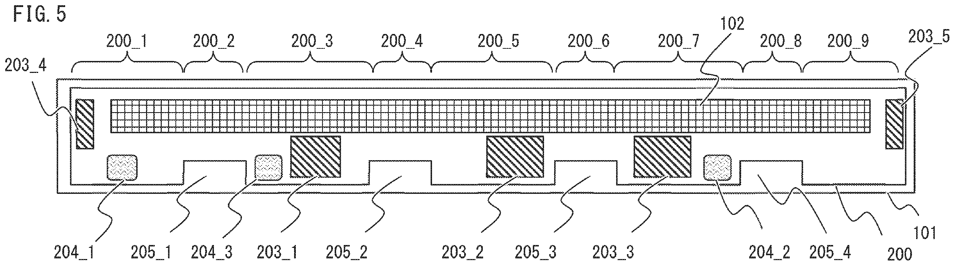

FIG. 5 is a schematic diagram showing one form of the light emitting device according to the present example.

On the rectangular substrate 101, a moisture-resistant ring 200, the light emitting region 102 in which light emitting pixels arranged in row and column directions are disposed, contact regions 203_1 to 203_5 electrically connected to the common electrode of the OLED, and pads 204_1 to 204_3 electrically connected to the contact regions are disposed.

In the present example, the moisture-resistant ring 200 is configured such that five wide-width portions 200_1, 200_3, 200_5, 200_7, and 200_9 and four narrow-width portions 200_2, 200_4, 200_6, and 200_8 are alternately arranged. The narrow-width portions 200_2, 200_4, 200_6, and 200_8 are parts of which widths in the short side direction are shorter than widths of the wide-width portions 200_1, 200_3, 200_5, 200_7, and 200_9 in the short side direction. Similarly to the first embodiment, the wide-width portions 200_1, 200_3, 200_5, 200_7, and 200_9 may have the second parts, and the narrow-width portions 200_2, 200_4, 200_6, and 200_8 may have the first parts. Here, an example is shown in which there are five wide-width portions and four narrow-width portions, but the number thereof is not particularly limited.

Due to the presence of the wide-width portions 200_1, 200_3, 200_5, 200_7, and 200_9, the outer circumferential shape of the moisture-resistant ring 200 includes a plurality of depressed parts. In the present example, the parts are referred to as depressed portions 205_1 to 205_4 of the moisture-resistant ring. The depressed portions 205_1 to 205_4 each are a direct-contact region for coming into direct contact with the ribs as a part of the mask for deposition in the film formation process. In the present example, a plurality of depressed portions 205_1 to 205_4 of the moisture-resistant ring 200 are disposed along the long side of the light emitting device. Therefore, an interval for disposition of the rib direct-contact regions on the silicon wafer can be narrowed, and deformation of the deposition mask can be suppressed. Further, by narrowing the interval for disposition of the rib direct-contact regions, a length of each depressed portion as the direct-contact region in the long side direction can be shortened, and the interval between the first contact region and the second contact region can be reduced. Therefore, the resistance of the common electrode in the center of the light emitting device can be further reduced, and the brightness shading of the light emitting device can be further suppressed. Since the contact regions 203_1 to 203_3 of the common electrode and the power source wiring and the depressed portions 205_1 to 205_3 of the moisture-resistant ring are alternately disposed on the light emitting device, the resistance of the common electrode can be reduced at a plurality of locations.

Since the members other than the light emitting region, such as the contact region of the light emitting device, are disposed in series in the long side direction, the light emitting device can be further miniaturized, the yield on the silicon wafer can be increased, and the costs thereof can be reduced. In the present specification, "members A and B are disposed in series in the first direction" means that there is a part where the members A and B overlap as viewed in plan from the first direction relative to a plane perpendicular to the first direction.

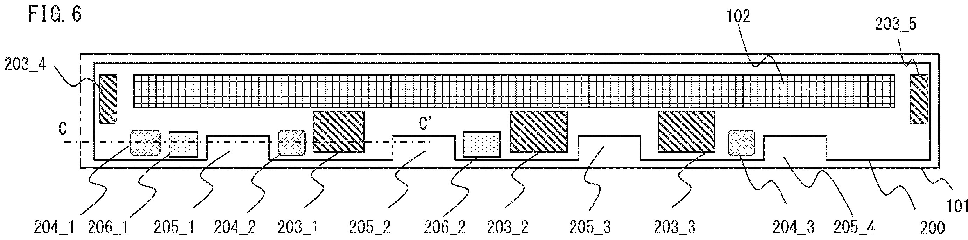

FIG. 6 is a schematic diagram showing another form of the light emitting device according to the present example. Compared to the light emitting device of FIG. 5, some circuits 206_1 and 206_2 for driving the light emitting devices are added. The circuits 206_1 and 206_2 are disposed in series in the long side direction. In other words, the circuits 206_1 and 206_2 are additionally disposed so as to overlap in a plan view relative to a plane perpendicular to the long side direction. The circuits 206_1 and 206_2 are also disposed in series together with the contact regions 203_1 to 203_3 and the pads 204_1 to 204_3 in the long side direction.

Specific examples of the circuits 206_1 and 206_2 include an input protection circuit, an input circuit to which data for each driving is input, and a logic circuit for processing the data, but are not limited thereto. Regardless of the types of circuits, it is possible to reduce the length of the light emitting device in the short side direction by providing a circuit region at positions the same as the positions of the contact region and the pad region and disposing the circuits in the circuit region.

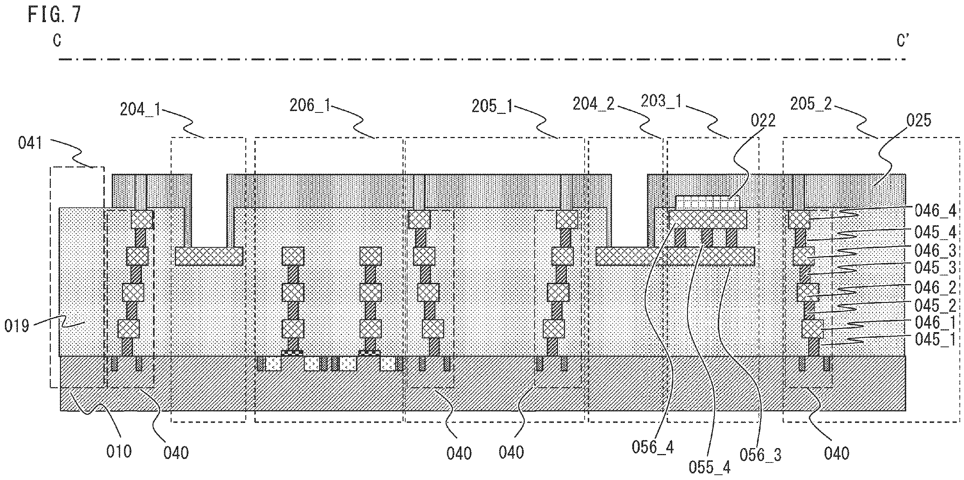

FIG. 7 is a cross-sectional view of the light emitting device of FIG. 6 taken along the line C-C'. The structure is the same as that of FIG. 4A except that the circuit 206_1 is added.

By adopting the configuration described in the present example, it is possible to effectively suppress shading of the brightness of the light emitting device.

### Example 3

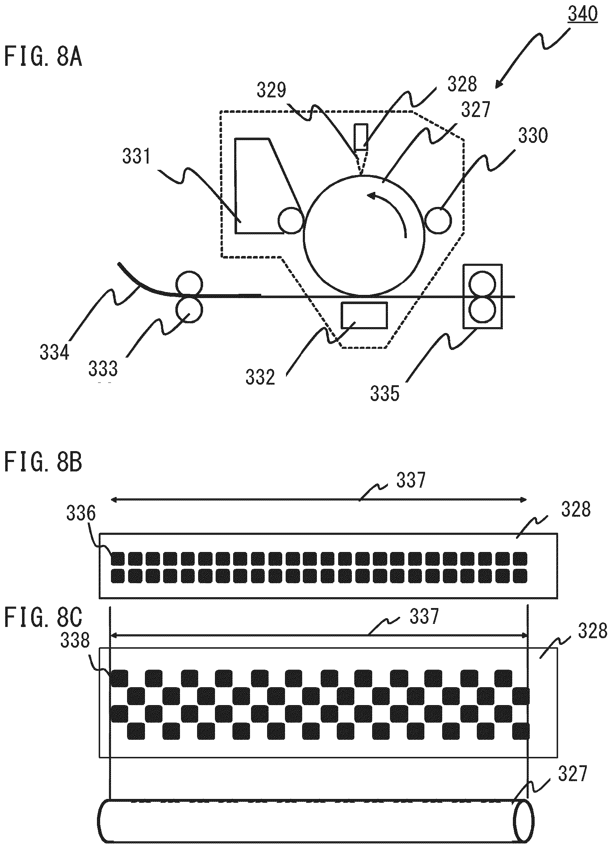

FIG. 8A is a schematic diagram of an image forming apparatus 340 according to an example of the present disclosure. The image forming apparatus 340 has a photosensitive member 327, an exposure section 328, a development section 331, a charging section 330, a transfer section 332, a transport section 333, and a fixing section 335. The photosensitive member 327 is irradiated with light 329 from the exposure section 328, and an electrostatic latent image is formed on a surface of the photosensitive member 327. In the exposure section 328, the light emitting device according to Example 1 or Example 2 is applied as an exposure light source. The development section 331 has a toner, or the like. The charging section 330 charges the photosensitive member 327. The transfer section 332 transfers a developed image to a recording medium 334. The transport section 333 transports the recording medium 334. The recording medium 334 is, for example, paper. The fixing section 335 fixes the image formed on the recording medium 334.

FIGS. 8B and 8C are schematic diagrams showing a state where a plurality of light emitting devices 336 are disposed in the exposure section 328. Line 337 indicates a direction parallel to an axis of the photosensitive member, and indicates a direction in which the OLEDs are arranged. The direction is the same as a direction of the axis about which the photosensitive member 327 rotates. The direction can also be called a major axis direction of the photosensitive member 327. In FIG. 8B, the OLEDs are disposed along the major axis direction of the photosensitive member 327.

FIG. 8C shows disposition of light emitting devices 338 different from that of FIG. 8B. In this example, the light emitting devices are disposed in four columns in a direction (row direction) that intersects with the major axis direction. The light emitting devices 338 are disposed to sequentially form a first column, a second column, a third column, and a fourth column. In each of the first column and the second column, the light emitting sections are disposed alternately in the column direction. In other words, the light emitting devices 338 in the first column and the light emitting devices 338 in the second column are disposed at different positions in the row direction.

In the first column, the plurality of light emitting devices 338 are disposed at intervals. In the second column, the light emitting devices are disposed at positions corresponding to spaces between the light emitting devices 338 in the first column. That is, the plurality of light emitting sections are also disposed at intervals in the row direction.

The disposition in FIG. 8C may be modified as, for example, a grid disposition, a hound's tooth disposition, or a checkerboard disposition.

The invention is not limited to the above-mentioned embodiments, and various changes and modifications are possible without departing from the spirit and scope of the invention. Therefore, claims are attached to publicize the scope of the invention.

According to the present disclosure, it is possible to improve the yield of the light emitting devices and achieve reduction in costs.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A light emitting device comprising:
a substrate which has a polygonal shape and a long side direction of which is a first direction and a short side direction of which is a second direction;
a light emitting region including a plurality of light emitting elements provided on the substrate and each of the plurality of light emitting elements having a first electrode and a second electrode, with the light emitting layer being interposed therebetween;
a first contact region which is disposed in a peripheral region of the light emitting region of the substrate and which is electrically connected to the second electrode; and
a moisture-resistant ring which is provided on the substrate and which surrounds the light emitting region and the first contact region, wherein
the first electrode of each of the plurality of light emitting elements is electrically separated, and the second electrode is a common electrode shared by the plurality of light emitting elements,
the moisture-resistant ring has a first part and a second part disposed along one long side of the light emitting region of the substrate, the first part being at a position at a first distance from the long side in the second direction, and the second part being at a position at a second distance from the long side in the second direction,
the first distance is greater than the second distance, and
the first contact region is disposed between the second part of the moisture-resistant ring and the light emitting region in the second direction.

2. The light emitting device according to claim 1, wherein
the moisture-resistant ring has a first narrow-width portion having the first part on a side of the one long side and a first wide-width portion having the second part on the side of the one long side,
the first narrow-width portion of the moisture-resistant ring is between the first wide-width portion and a second wide-width portion in the first direction,
the first contact region is provided in the first wide-width portion, and
a second contact region electrically connected to the second electrode is provided in the second wide-width portion.

3. The light emitting device according to claim 2, wherein
positions of the first narrow-width portion and the first wide-width portion in the second direction are different from each other relative to the one long side, and
positions of the first narrow-width portion and the first wide-width portion in the second direction coincide with each other relative to the other long side.

4. The light emitting device according to claim 3, wherein
the first contact region is disposed on the side of the one long side relative to the light emitting region, in the first wide-width portion of the moisture-resistant ring.

5. The light emitting device according to any one of claims 1 to 4, further comprising:
a pad which is adjacent to the second part and disposed in the region on the light emitting region side of the moisture-resistant ring and which is electrically connected to the first contact region.

6. The light emitting device according to any one of claims 1 to 5, further comprising:
a circuit region which is adjacent to the second part and disposed in the region on the light emitting region side of the moisture-resistant ring and in which a part of a circuit for driving the light emitting element is formed.

7. The light emitting device according to claim 1, wherein
the moisture-resistant ring has a first narrow-width portion having the first part on the side of the one long side and a first wide-width portion having the second part on the side of the one long side, and
the moisture-resistant ring includes the first narrow-width portion, a second narrow-width portion disposed on the side of the one long side of the light emitting region, and the first wide-width portion disposed between the first narrow-width portion and the second narrow-width portion.

8. A light emitting device comprising:
a substrate which has a polygonal shape and a long side direction of which is a first direction and a short side direction of which is a second direction;
a light emitting region including a plurality of light emitting elements provided on the substrate and each of the plurality of light emitting elements having a first electrode and a second electrode, with the light emitting layer being interposed therebetween;
a first contact region and a second contact region which are disposed in a peripheral region of the light emitting region of the substrate and which are electrically connected to the second electrode; and
a moisture-resistant ring which is provided on the substrate and which surrounds the light emitting region, the first contact region, and the second contact region, wherein
the first electrode of each of the plurality of light emitting elements is electrically separated, and the second electrode is a common electrode shared by the plurality of light emitting elements,
the moisture-resistant ring comprises a first depressed portion on a side of one long side, and
the first depressed portion of the moisture-resistant ring is disposed between the first contact region and the second contact region.

9. The light emitting device according to claim 8, wherein
the moisture-resistant ring further comprises a second depressed portion on the side of the one long side, and
the second depressed portion, the first contact region, the first depressed portion, and the second contact region are disposed in this order.

10. The light emitting device according to claim 8, wherein
the first contact region, the second contact region, and the first depressed portion of the moisture-resistant ring are disposed between the light emitting region and one long side end portion of the substrate.

11. The light emitting device according to claim 8, wherein
the first contact region, the first depressed portion of the moisture-resistant ring, and the second contact region are disposed in series in the first direction.

12. The light emitting device according to claim 8, wherein
the first depressed portion of the moisture-resistant ring is an area with which a part of a mask for deposition comes into contact in a case where the light emitting element is formed.

13. The light emitting device according to claim 8, further comprising:
a first pad and a second pad which are disposed in the peripheral region of the light emitting region of the substrate and which are electrically connected to the first contact region and the second contact region, respectively, wherein
the first contact region, the first pad, the first depressed portion of the moisture-resistant ring, the second contact region, and the second pad are disposed between the light emitting region and one long side end portion of the substrate.

14. The light emitting device according to claim 13, wherein
the first pad, the first contact region, the first depressed portion of the moisture-resistant ring, the second contact region, and the second pad are disposed in series in the first direction.

15. The light emitting device according to claim 8, further comprising:
a circuit region which is disposed in the peripheral region of the light emitting region of the substrate and in which a part of a circuit for driving the light emitting element is formed, wherein
the first contact region, the second contact region, the circuit region, and the first depressed portion of the moisture-resistant ring are disposed between the light emitting region and one long side end portion of the substrate.

16. The light emitting device according to claim 15, wherein
the first contact region, the circuit region, the first depressed portion of the moisture-resistant ring, and the second contact region are disposed in series in the first direction.

17. The light emitting device according to claim 8, further comprising:
a first pad and a second pad which are disposed in the peripheral region of the light emitting region of the substrate and which are electrically connected to the first contact region and the second contact region, respectively, and
a circuit region which is disposed in the peripheral region of the light emitting region of the substrate and in which a part of a circuit for driving the light emitting element is formed, wherein
the first contact region, the second contact region, the first pad, the second pad, the circuit region, and the first depressed portion of the moisture-resistant ring are disposed between the light emitting region and one long side end portion of the substrate.

18. The light emitting device according to claim 17, wherein
the first pad, the first contact region, the circuit region, the first depressed portion of the moisture-resistant ring, the second contact region, and the second pad are disposed in series in the first direction.

19. An image forming apparatus comprising:
a photosensitive member;
a charging section which charges the photosensitive member;
an exposure section which has the light emitting device according to any one of claims 1 to 18 and which forms an electrostatic latent image on a surface of the photosensitive member;
a development section which develops the electrostatic latent image; and
a transfer section which transfers the developed image to a recording medium.
